# EUROPÄISCHE PATENTANMELDUNG

(11) **EP 2 361 006 A2**
(43) Veröffentlichungstag der Anmeldung: **24.08.2011**
(21) Anmeldenummer: 11000832.3
(22) Anmeldetag: 03.02.2011
(51) Int. Cl.: H05K 7/20

(54) **Kühlsystem mit Lüfter für Photovoltaik-Wechselrichter**

(30) Priorität: 13.02.2010 DE 102010007902
(71) Anmelder: Adensis GmbH, 01129 Dresden (DE)
(72) Erfinder: Beck, Bernhard, 97332 Volkach OT Dimbach (DE)

(57) **Zusammenfassung**

Es wird ein Kühlsystem für elektronische Bauelemente vorgestellt, insbesondere für die IGBT's eines Wechselrichters (100) von einem Photovoltaikgenerator (102), mit einem geschlossenen, ein zirkulierendes Fluid (110) enthaltenden Kühlkreislauf (111). Der Kühlkreislauf umfasst ausgehend von den Bauelementen in Zirkulationsrichtung einen belüfteten Kühler (116), der von dem Fluid durch- oder umströmt wird, um Wärme an die Umgebung abzugeben. Hinter dem Kühler befindet sich ein erster Latentwärmespeicher (120) mit dem Fluid in Wirkverbindung steht. Es ist vorteilhaft, wenn hinter dem ersten Latentwärmespeicher (120) ein zweiter Latentwärmespeicher (122) angeordnet ist, der auf eine andere Phasenübergangstemperatur ausgelegt ist, als der erste Latentwärmespeicher (120). Es wird das Ziel angestrebt, den Wechselrichter mit möglichst wenig Eigenaufwand an elektrischer Energie auch mittags mit ungedrosselter Leistung zu betreiben.

## Beschreibung

Die Erfindung bezieht sich auf ein Kühlsystem für elektronische Bauelemente, insbesondere für die IGBT's eines Wechselrichters, mit einem geschlossenen, ein zirkulierendes Fluid enthaltenden Kühlkreislauf, welcher ausgehend von den Bauelementen in Zirkulationsrichtung einen belüfteten Kühler umfasst, der von dem Fluid durch- oder umströmt wird, um Wärme an die Umgebung abzugeben. Als Anwendungsgebiet wird insbesondere an die Photovoltaik gedacht. Dort werden Wechselrichter in der Größe von zur Zeit ca. 5 kW verbaut, wobei bei einer Gesamtleistung eines Kraftwerks von 1 Megawatt oder mehr eine entsprechende Vielzahl eingesetzt werden muss, um den von den Photovoltaikmodulen erzeugten Gleichstrom in einen Wechselstrom zu überführen, der in das Versorgungsnetz eingespeist wird.

Die Wechselrichter enthalten Leistungstransistoren, die in der Regel IGBTs (Insulated Gate Bipolar Transistor) sind. Diese haben die Eigenschaft, dass Temperaturwechsel und -veränderungen deren Lebensdauer stark beeinträchtigen. Bei der Erzeugung von Solarstrom ist ein solcher Wechsel aber ohne zusätzliche Maßnahmen inhärent gegeben, da die den IGBTs zugeführte Leistung stark von unvorhersehbaren Faktoren, wie z.B. der Intensität der Solarstrahlung, dem Durchzug von Wolken, der Außentemperatur etc. abhängt. Die an ein und demselben Tag generierte Leistung kann aufgrund von Wetter bedingten Lastwechseln zwischen 10% und 100% der Normleistung variieren. Die IGBTs reagieren entsprechend mit Abkühlung und Aufheizung, was zu vermeiden ist. Es wurde festgestellt, dass häufige Temperaturschwankungen von IGBTs zwischen z.B. 60° C und 90° Celsius schädlicher sind, als eine dauerhafte, gleichmäßig vorliegende höhere Betriebstemperatur von z.B. 100° C. Desweiteren ist die von dem Kühlsystem verbrauchte Leistung, welche hauptsächlich dem Lüfter zuzuordnen ist, ein Faktor, der die Gesamteffizienz der PV-Anlage direkt belastet.

Der Erfindung liegt daher die Aufgabe zugrunde, das Kühlsystem technisch einfach und billig auszuführen, wobei nur ein minimaler Aufwand an Regel- und Steuertechnik erforderlich sein soll und gleichzeitig nur ein kleiner Eigenverbrauch an elektrischer Energie des Kühlsystems anfallen soll. Darüber hinaus soll die Lebensdauer der Schalttransistoren durch Vergleichmäßigung ihrer Betriebstemperatur erhöht werden.

Diese Aufgabe wird erfindungsgemäß dadurch gelöst, hinter dem Kühler ein erster Latentwärmespeicher mit dem Fluid in Wirkverbindung steht.

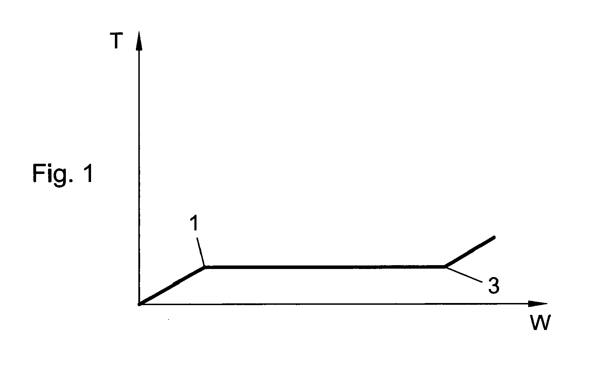

Das Verhalten eines Latentwärmespeichers soll dabei kurz anhand der Figur 1 erläutert werden. Der Latentwärmespeicher macht sich eine Eigenschaft von gewissen Stoffen zunutze, der zufolge bei einer Wärmezufuhr zu dem Speichermedium in einem definierten Bereich kein Temperaturanstieg des Speichermediums erfolgt. Die erwähnte Eigenschaft besteht dabei darin, dass die zugeführte Wärmeenergie dazu verwendet wird, zunächst einen Phasenwechsel durchzuführen, bevor ein Temperaturanstieg einsetzt. Ein einfaches Beispiel ist das Eis in einem Sektkühler, das bei Erwärmung durch Raumtemperatur nicht sofort zu Wasser mit Raumtemperatur auftaut, sondern die Wärmezufuhr erst dazu verwendet wird, die feste, solide Phase in die Flüssigkeitsphase bei annähernd gleicher Temperatur umzuwandeln. Die Figur 1 zeigt einen typischen Verlauf derartiger Stoffe. Dabei ist die Temperatur über die gespeicherte Wärme aufgetragen. Zunächst erfolgt ein linearer Anstieg der Temperatur bei Zufuhr von Wärme. Ab einem ersten Knickpunkt 1 wird weiterhin Wärme in das Material eingespeichert, ohne dass es zu einer Temperaturerhöhung des Materials kommt. Die während des Phasenübergangs eingespeicherte Wärme wird auch als versteckte oder latente Wärme bezeichnet. Im Falle eines Phasenübergangs fest - flüssig ist die latente Wärme gleich der Schmelz- oder Kristallisationswärme des Speichermaterials. Ist der Phasenübergang am zweiten Knickpunkt 3 abgeschlossen, ist das Speichermaterial insgesamt flüssig und es kommt zu einer weiteren Temperaturerhöhung des Speichermediums. Die in Figur 1 dargestellte Kurve ist reversibel und wird je nach zugeführter oder entnommener Wärme nach rechts, beziehungsweise nach links durchlaufen. Diese Eigenschaft macht sich vorliegende Erfindung zunutze, um einen minimalen Verbrauch an Eigenenergie zu erzielen, indem die gespeicherte Wärme nicht mit elektrischem Energieaufwand abtransportiert wird, sondern in dem Latentwärmespeicher zwischengespeichert wird, um sie über Nacht durch natürliche Kühlung aufgrund von Konvektion mit der Umgebungsluft zu entsorgen.

Bei hoher Sonneneinstrahlung werden die IGBTs rasch auf eine Betriebstemperatur von z.B. 90° C aufgeheizt, ohne dass von dem Latentwärmespeicher Gebrauch gemacht wird. Ein weiteres Aufheizen wird dadurch verhindert, dass die überschüssige Wärme, die nicht zur Aufrechterhaltung der gewählten Betriebstemperatur benötigt wird, in den Latentwärmespeicher eingespeist wird, bis dieser voll ist. Darüber hinaus gehende Wärme wird in die Umgebung abgeführt. Erfolgt dann eine Reduktion in der PV-Leistung, z.B. durch eine Verdunkelung durch eine Regenwolke mit Abkühlung der photovoltaischen Zellen, würden die IGBTs ohne weitere Maßnahmen unter die gewählte Betriebstemperatur fallen. Dies wird durch den Latentwärmespeicher verhindert, der einen Teil seiner Wärme an die IGBTs zurückgibt, um deren Temperatur in einem gewünschten Temperaturbereich zu halten. Der eingestellte Temperaturbereich liegt z.B. plus 2°C bis minus 2°C um die über das Material eingestellte Wunschtemperatur. Diese Rückführung an Wärmeenergie unter gleichzeitiger Leerung des Latentwärmespeichers spart einen später womöglich anfallenden zusätzlichen Verbrauch an Energie für den Lüfter.

Der Kühler kann passiv, das heißt ohne Lüfter betrieben werden. Wenn dann noch die für die Zirkulation des Fluides zuständige Pumpe auf eine feste Förderleistung eingestellt ist, kann das Kühlsystem komplett ohne jede Regel- und Steuereinheit ausgelegt werden. Vorteilhaft ist es allerdings, wenn der Kühler aktiv belüftet und in seiner Leistung regelbar ist, ggf. mit einer in seiner Drehzahl ebenfalls regelbaren Umwälzpumpe für die Zirkulation des Fluides. Dann kann die Kühlleistung immer auf den optimalen Punkt gefahren werden. Der optimale Punkt ist dabei die Konstanthaltung der Fluidtemperatur vor dem Kühler bei möglichst geringem Eigenverbrauch an elektrischer Energie. Die geeignetste Position vor dem Kühler ist unmittelbar am Ausgang des Bauteilgehäuses, also nach dem Austreten des Fluides aus dem zu temperierenden Bauteilebereich.

Je nach baulichen Gegebenheiten ist es vorteilhaft, wenn hinter dem ersten Latentwärmespeicher ein zweiter Latentwärmespeicher angeordnet ist. Diese Ausspaltung des Latentwärmespeichers in zwei getrennte Aggregate erleichtert eine optimale Raumausnutzung, insbesondere, wenn das Kühlsystem als Einheit zusammen mit dem Wechselrichter und ggf. noch einem Transformator konstruiert wird. Dan wiederum ist es besonders vorteilheft, wenn der zweite Latentwärmespeicher auf eine andere Phasenübergangstemperatur ausgelegt ist, als der erste Latentwärmespeicher. Da bei einem Latentwärmespeicher bauartbedingt zugeführte Wärme nicht zu einer Temperaturerhöhung führt kann keine Aussage über die bereits aufgenommene Wärmemenge getroffen werden. Eine entsprechende Aussage wäre nur optisch bei einem gläsernen Speichergehäuse möglich, indem durch Inaugenscheinnahme festgestellt wird, wie viel Parraffin oder sonstiges eingesetztes Material noch fest ist. Hier ermöglichen zwei oder mehr Latentwärmespeicher mit jeweils sich unterscheidender Phasenwechseltemperatur Abhilfe. Wenn einer der Latentwärmespeicher seinen Phasenwechsel vollständig abgeschlossen hat, wird zusätzlich eingebrachte Wärmeenergie zu einem relativ steilen Temperaranstieg führen, der mittels eines Sensors gemessen wird. Der Sensor ist zum Beispiel zwischen den beiden Latentwärmespeichern angeordnet und misst die Temperatur des Fluids. Der zu erwartende Temperaturanstieg entspricht dabei der Differenz der beiden Phasenübergangstemperaturen der betrachteten Latentwärmspeicher. Aufgrund der eintretenden Energieaufnahme über Phasenübergang des Speichers mit der höheren Phasenwechseltemperatur wird die Temperatur dann vorerst wieder konstant bleiben, bis der zweite Latentwärmespeicher voll ist, d.h. sein gesamter Inhalt von fest in die flüssige Phase gewandelt ist.

Die Information, wann mit der Füllung des zweiten Latentwärmespeichers begonnen wird, ermöglicht eine Abschätzung, wie lange die Photovoltaikanlage noch bei der hohen vorliegenden Verlustleistung der IGBT's, die über der vom Kühler zu bewältigenden, also in die Umgebung abgegebene Leistung liegt, betrieben werden kann. Der Betreiber der Anlage kann sich dann darauf einstellen und zum Beispiel eine Zusatzenergiequelle (z.B. Dieselaggregat, Gasturbine, Brennstoffzelle etc.) zur Lieferung vorbereiten, falls sein Liefervertrag an den Netzbetreiber für die anliegende Tageszeit eine Mindesteinspeiseleistung vorsieht. Insbesondere während der Mittagszeit wird so eine höhere Belastung des Wechselrichters ermöglicht.

Eine besonders vorteilhafte Ausführungsform der Erfindung sieht vor, dass der erste und/oder der zweite Latentwärmespeicher durch ein Umgehungsrohr überbrückt wird, welches von einem Ventil freigegeben wird, solange die Temperatur des Fluides am Lüfterausgang einen vorgebbaren Grenzwert unterschreitet. Dieser Einsatz eines Bypass sorgt dafür, dass die über Nacht abgekühlten Latentwärmespeicher nicht frühzeitig an ihre Phasenwechseltemperatur herangeführt werden. Es wird solange auf die vom Kühler abgeführte Wärmeleistung gesetzt, bis dieser nicht mehr in der Lage ist, die Temperatur des Fluides unterhalb der gewünschten Temperatur am Ausgang des IGBT Gehäuses zu halten. Dann erst wird das Umgehungsrohr mittels des Ventils gesperrt und das Fluid wird durch den oder die Latentwärmespeicher umgelenkt. Nach der Freigabe des Strömungsflusses über die Latentspeicher wird zunächst deren Latentmaterial aufgeheizt, bis es an die Phasenwechseltemperatur herangeführt ist und anschließend wird die Wärmeabsorption mittels des Phasenübergangs begonnen. Im Ergebnis wird mit Hilfe des Bypass also die Kapazität des oder der Latentwärmespeicher um den Betrag erhöht, der zum Aufheizen des Speichervolumens anfällt.

Schließlich ist es vorteilhaft, wenn einer der Latentwärmespeicher in den Kühlkreislauf zuschaltbar ist. Auch dadurch lässt sich eine genau vorhersagbare Restbetriebszeit unter der vorliegenden Last errechnen, deren Kenntnis für den Betreiber nützlich sein kann.

Wie bereits zuvor angedeutet ist es vorgesehen, das Kühlsystem als Baueinheit zusammen mit einem Transformator, dem Wechselrichter und einer Schaltvorrichtung vorzusehen. So kann der Kühlkreislauf an ein Kühlelement des Transformators derart angekoppelt werden, dass das Fluid den Kühler, den Latentwärmespeicher und das Kühlelement durchströmt.

Weitere Vorteile und Ausgestaltungen der Erfindung ergeben sich aus der Beschreibung eines Ausführungsbeispiels anhand der Figuren. Es zeigen:
- Fig. 1: einen typischen Verlauf des Temperaturanstiegs eines Latentwärmespeichers über die eingebrachte Wärmemenge;
- Fig. 2: eine Übersicht zum erfindungsgemäßen Kühlsystem;
- Fig. 3: eine Baueinheit als Verbindungsmodul zwischen einem PV-Generator und einem Netzbetreiber;
- Fig. 4: eine schematische Übersicht der Temperiervorrichtung;
- Fig. 5: eine Detailansicht aus Fig. 2;
- Fig. 6: ein Grundelement eines Latentwärmespeichers;
- Fig. 7: eine Aufsicht auf eine Anordnung von neun in Reihe geschalteter Grundelemente zur Bildung eines leistungsstarken Latentwärmespeichers;
- Fig. 8: eine Seitenansicht der Anordnung nach Fig. 5;
- Fig. 9: ein Grundelement mit Lüftungsfinnen;
- Fig. 10: einen Wärmetauscher für elektronische Bauelemente;
- Fig.11: eine alternative Anordnung von Grundelementen; und
- Fig.12: symbolisierte Darstellung von Kühlvarianten.

In der Figur 1 ist der Temperatur T eines Latentwärmematerials, insbesondere Paraffin, über die im Material gespeicherte Wärme W aufgezeichnet. Wie im einleitenden Teil bereits diskutiert, sieht man einen ersten Knickpunkt 1, an dem die Phasenumwandlung des Materials von fest nach flüssig einsetzt und einen zweiten Knickpunkt 3, an dem dieser Prozess abgeschlossen ist und das Material in Gänze als Flüssigkeit vorliegt. Im Bereich zwischen dem ersten und dem zweiten Knickpunkt 1,3 bleibt die Temperatur T weitgehend konstant. Diese Eigenschaft wird sich bei der im Folgenden beschriebenen Vorrichtung zunutze gemacht.

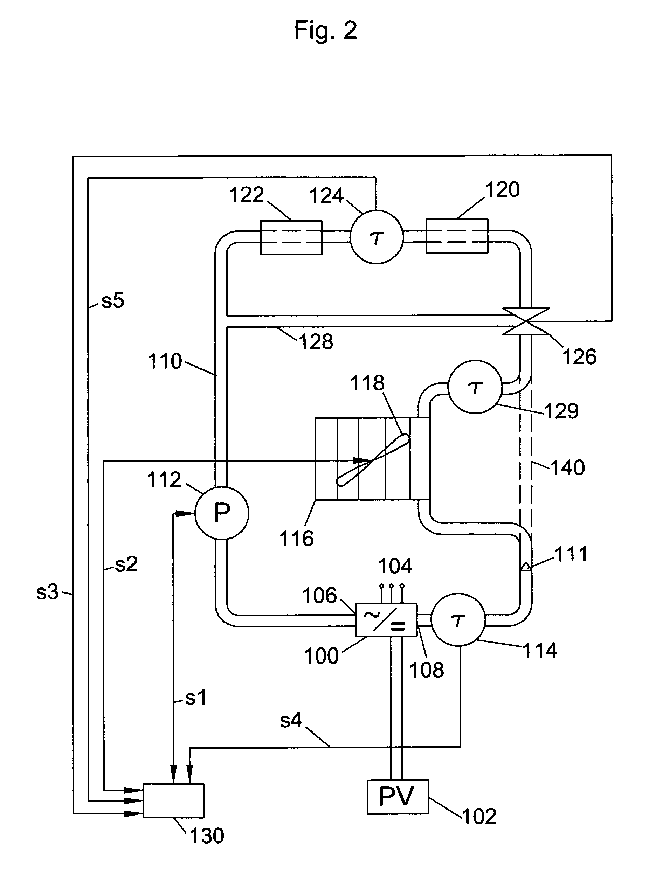

In der Figur 2 ist mit 100 ein Wechselrichter bezeichnet, der als elektronische Bauelemente mehrere IGBT's beinhaltet. Der Wechselrichter 100 ist eingangsseitig an einen Solargenerator 102 und ausgangsseitig an ein Versorgungsnetz 104 angeschlossen. Der Wechselrichter 100 hat eine Zulauföffnung 106 und eine Ablauföffnung 108 für ein Fluid 110, welches in einem Rohrsystem in Richtung des Pfeils 111 zirkuliert. Dazu dient eine Umwälzpumpe 112, die im Strömungspfad des Fluides 110 angeordnet ist. Hinter der Ablauföffnung 108 befindet sich ein erster Temperaturfühler 114, der die Temperatur des Fluides 110 zwischen der Austrittsöffnung 108 und einem Kühler 116 misst. Der Kühler 116 ist vorzugsweise mittels eines Lüfters oder Propellers 118 zwangsbelüftet, so dass seine Kühlleistung über die Drehzahl des Lüfters 118 einstellbar ist. In Zirkulationsrichtung gesehen hinter dem Kühler 116 sind ein erster und ein zweiter Latentwärmespeicher 120, bzw. 122 in Reihe angeordnet. Zwischen dem ersten und dem zweiten Latentwärmespeicher 120, 122 ist ein zweiter Temperaturfühler 124 angeordnet, der die Temperatur des Fluides 110 in diesem Strömungszweig misst. Ein Zwei- oder Dreiwegeventil 126 zwischen dem Kühler 116 und dem ersten Latentwärmespeicher 120 ermöglicht es, einen Bypass oder eine Umgehungsleitung 128 anstelle der beiden Latentwärmespeicher 120,122 in den Zirkulationskreislauf oder Strömungspfad des Fluides 110 einzubinden.

An die Umwälzpumpe 112, den Lüfter 118 und das Zwei- oder Dreiwegeventil sind Steuer- und Signalleitungen S1 bis S3 geführt, über die diese steuerbaren Bauteile angesteuert werden können, d.h.im Einzelnen, dass die Drehzahl der Umwälzpumpe 112, die Drehzahl des Lüfters 118 und die Stellung des Zweiwegeventils 126 verändert und eingestellt werden können. Die Steuer- und Signalleitungen S1 bis S3 sind an eine Auswerte- und Steuereinheit 130 angeschlossen, die die aktuellen Daten bewertet und gegebenenfalls ein Steuersignal zur erforderlichen Änderung abgibt. An der Steuer- und Regeleinheit 130 sind weiterhin der erste und der zweite Temperaturfühler 114, 124 über zugeordnete Signalleitungen S4 und S5 angeschlossen.

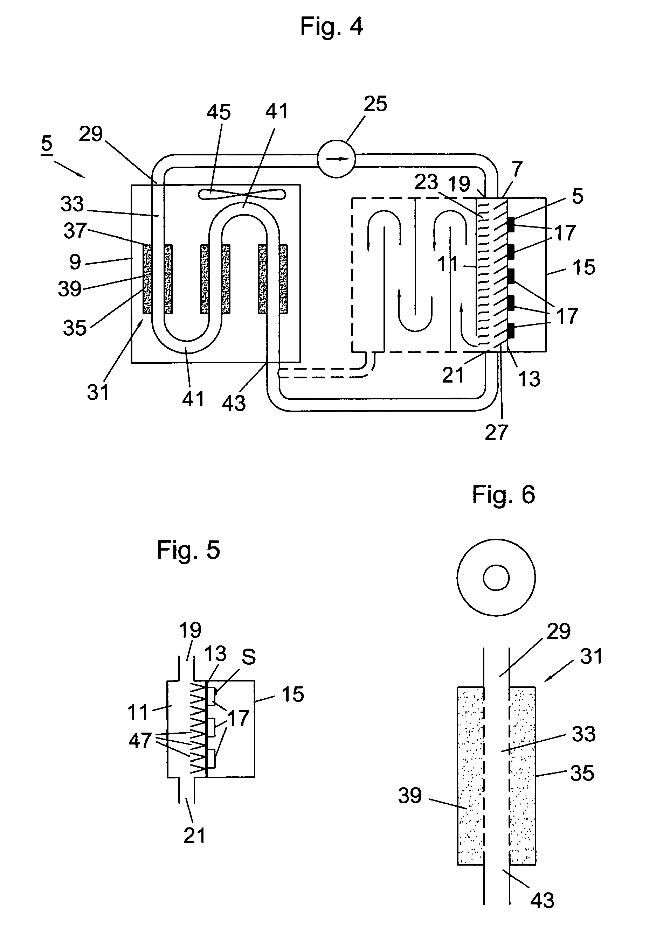

Der Betriebsprozess des Kühlsystems läuft folgendermaßen ab, wobei von einem Start des PV-Generators 102 früh am Morgen bei abgekühlten und entsprechend entleerten Latentwärmespeichem 120,122 ausgegangen wird. Der PV-Generator 102 nimmt seinen Betrieb auf, unter Umständen unter Zuhilfenahme der anhand der späteren Figuren 4 bis 12 noch beschriebenen Vorwärmung der IGBT's des Wechselrichters 100. Die Sonneneinstrahlung ist noch relativ gering und die Umwälzpumpe 112 wird mit kleiner Drehzahl betrieben. Das Zwei- oder Dreiwegeventil 126 ist so gestellt, dass der Bypass 128 die beiden Latentwärmspeicher 120, 122 überbrückt. Die über die natürliche Konvektion erreichbare Kühlleistung des Kühlers 116 reicht aus, um die IGBT's auf die gewünschte Betriebstemperatur zu halten. Die vom ersten Temperaturfühler 114 gemessene Temperatur des Fluides 110 ist dabei ein Maß für die gewünschte Solltemperatur an den IGBT's.

Bei zunehmender Sonneneinstrahlung erhöht sich der Bedarf an abzuführender Verlustleistung des Wechselrichters 100, und die Drehzahl der Umwälzpumpe wird von der Steuer- und Regeleinheit 130 erhöht. Zusätzlich wird der Lüfter 118 in Betrieb genommen, sofern eine Erhöhung der Drehzahl der Umwälzpumpe 112 keine nennenswerte weitere Wärmeabfuhr zeitigt oder aber der Energieverbrauch der Umwälzpumpe 112 unwirtschaftlicher wäre, als der in Kombination vorliegende Betrieb von Lüfterpropeller 118 plus Umwälzpumpe 112. Die Steuer- und Regeleinheit 130 optimiert also die beiden Drehzahlen von der Umwälzpumpe 112 und dem Lüfter 118 derart, dass sich bei geringstem elektrischem Energieverbrauch in Summe die notwendige Wärmeabfuhrleistung einstellt. Dabei kann die Drehzahl des Lüfters 118 auch Null sein. Bei weiter zunehmender Leistung des PV-Generators 102 sind die beiden Parameter - Drehzahl Umwälzpumpe 112 und Drehzahl Lüfterpropeller 118 - ausgereizt, und die zur Einhaltung der Fluidtemperatur notwendige Wärmeabfuhr muss in die Latentwärmespeicher 120 und 122 erfolgen. Dazu wird das Zwei- oder Dreiwegeventil 126 umgestellt, so dass anstelle des Bypass 128 der Pfad mit den Latentwärmespeichem 120, 122 in den Zirkulationsweg eingebaut wird. Der Zeitpunkt der Umschaltung kann anstelle eines Heranziehens der Überschreitung eines Temperaturgrenzwerts am ersten Temperaturfühler 114 auch mit Hilfe der Überschreitung eines niedrigeren Temperaturgrenzwertes an einem dritten Temperaturfühler 129, der unmittelbar hinter dem Ausgang des Kühlers 116 angeordnet ist, ermittelt werden.

Eine alternative Betriebsführung modifiziert obige Vorgehensweise, indem auf Vorrat gekühlt wird, um z.B. an einem heißen, wolkenlosen Nachmittag eine Vorratskapazität an Wärmespeichermöglichkeit anzulegen.

Die beiden Latentwärmespeicher 120 und 122 unterscheiden sich zumindest in der Phasenübergangstemperatur ihres Basismaterials, die z.B. um fünf C° auseinanderliegen. Dabei kann die jeweilige Speichergröße so gewählt sein, dass der Latentwärmespeicher mit der kleineren Phasenwechseltemperatur, z.B. der zweite Latentwärmespeicher 122 neunzig % der Gesamtkapazität aufweist und der erste Latentwärmespeicher 120 mit der höheren Phasenwechseltemperatur lediglich 10% zur Gesamtkapazität beiträgt. Die Information, wann mit der Füllung des ersten Latentwärmespeichers 120 begonnen wird (nachdem der zweite Latentwärmespeicher 122 aufgrund der kleineren Phasenwechseltemperatur gefüllt ist), ermöglicht eine Abschätzung, wie lange die Photovoltaikanlage noch bei der hohen vorliegenden Verlustleistung der IGBT's, die oberhalb der vom Kühler 116 zu bewältigenden, also in die Umgebung abgegebene Leistung liegt, betrieben werden kann. Der Betreiber der Anlage kann sich dann darauf einstellen und zum Beispiel eine Zusatzenergiequelle (z.B. Dieselaggregat, Gasturbine, Brennstoffzelle etc.) zur Lieferung vorbereiten. Der kleinere Latentwärmespeicher 120 mit der höheren Phasenwechseltemperatur braucht dann lediglich auf wenige Minuten bis zum Erreichen seines Phasenwandlungsendes ausgelegt sein, eben solange, bis der Zusatzenergielieferant oder auch eine weitere, nicht gezeigte Kühlvorrichtung für das Fluid 110 einsatzbereit ist. Die gewünschte "Vorwarnzeit" wird also über die Kapazität bzw. Größe des ersten Latentwärmespeichers 120 eingestellt.

Wenn nach der Mittagshitze die Kühlanforderung wieder zurückgenommen werden kann, wird prinzipiell in der umgekehrten Reihenfolge verfahren. Lediglich prinzipiell, weil es sinnvoll ist, zunächst die Lüfterleistung zurückzufahren, um dort verbrauchte elektrische Energie zu sparen. Entsprechend der Lüfter-seitig reduzierten Wärmeabfuhr, wird dann die Differenz der reduzierten Lüfterleistung zur benötigten Wärmeabfuhrleistung weiter in die Latentwärmspeicher 120, 122 eingeleitet, um diese gegen Abend vollständig gefüllt zu haben. Sie werden nachts de facto zum Nulltarif abgekühlt, so dass per Saldo eine Energieersparnis vorliegt, indem der Lüfterbetrieb möglichst sparsam eingesetzt wird, um zunächst die Latentwärmespeicher 120, 122 aufzufüllen.

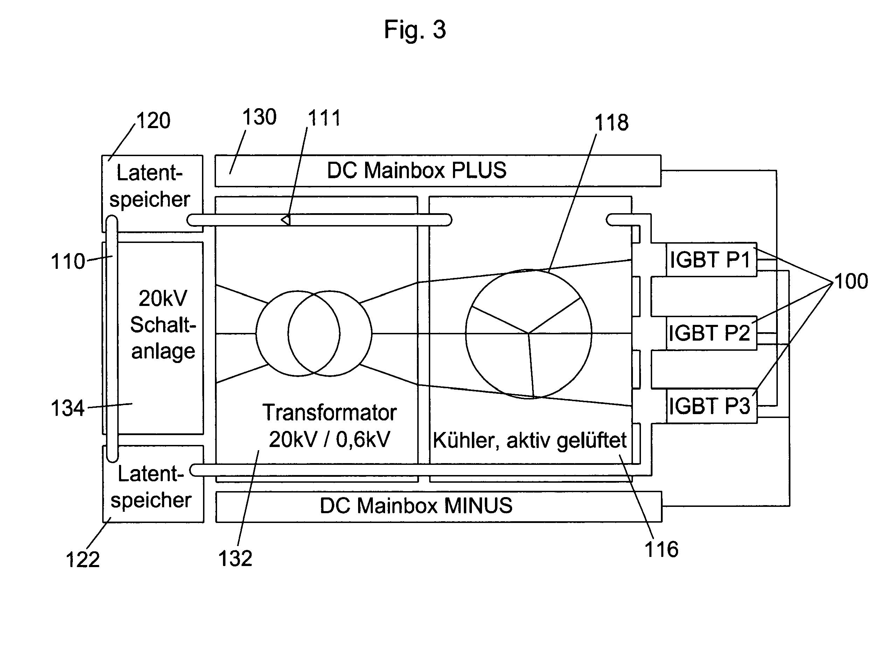

In der Figur 3 ist eine Baugruppe von in fester räumlicher Zuordnung zueinander bestehenden Komponenten gezeigt, die als Ganzes auf einer Transportpallette oder in einem Container an den PV-Generator 102 angeschlossen werden kann. Die Komponenten sind im Einzelnen: Der Wechselrichter 100, dargestellt durch seine zu kühlenden IGBT's, der Kühler 116 mit seinem Lüfter 118, der erste und der zweite Latentwärmespeicher 120, bzw. 122, die Regel- und Steuereinheit 130 sowie als bisher nicht aufgeführte Komponenten ein Transformator 132 und eine Schaltanlage 134. Der Transformator 1332 übersetzt die vom Wechselrichter in eine Wechselspannung überführte elektrische Energie vom PV-Generator 102, die dort zur Zeit auf einem Gleichspannungsniveau von 0,4 KV liegt, in eine Wechselspannung auf Mittelspannungsebene, hier am Beispiel z.B. 20 KV. Die Schaltanlage 134 dient dazu, den Wechselrichter 100 vom Versorgungsnetz zu trennen.

In der Figur 2 ist noch mit gestrichelten Linien ein weiterer Bypass 140 eingezeichnet, der parallel zum Kühler 116 geführt ist. Über die Ansteuerung eines weiteren Ventils 142, dass analog zu dem ersten Ventil 126 als Zweiwegeventil oder als Dreiwegeventil mit Beimischschaltung ausgeführt sein kann, wird der Bypass anstelle des Kühlers 116 oder zusammen als Parallelschaltung mit dem Kühler 126 in den Zirkulationskreislauf eingebunden. Der weitere Bypass hat den Zweck, die in dem Latentwärmespeicher 120, 122 gespeicherte Wärme zum Temperaturerhalt der IGBT's über Nacht auszunutzen. Es wird also nicht der gesamte Wärmeinhalt des Latentwärmespeichers 120, 122 über Nacht in die Umgebung angegeben, sondern ein Teil wird genutzt, um die Temperierung der elektronischen Bauelemente vorzunehmen.

Wie es aus der Figur 3 ersichtlich ist, sind der Transformator 132 und die Schaltanlage 134 in den durch den Pfeil 111 symbolisierten Kühlkreislauf eingebunden. Der Transformator 132 besitzt aufgrund seines hohen, auf den Einbau der Metalle Eisen und Kupfer basierenden Gewichtes eine hohe Wärmekapazität, die bis zum Erreichen seiner zulässigen Betriebstemperatur ebenfalls als zusätzlicher Wärmespeicher genutzt werden kann. Ebenso bieten die an dem Transformator üblicherweise angeordneten Kühlfinnen eine weitere Möglichkeit zum Wärmeabtransport. Die Einbindung der Schaltanlage 134 mit eher geringen Massen ist weniger wichtig und kann auch unterbleiben. Da die zulässige Betriebstemperatur des Transformators 132 bekannt ist, muss, falls diese niedriger liegt als die einzustellende Fluidtemperatur, mit einem weiteren Bypass (nicht gezeigt) gearbeitet werden, mittels dem der Transformator 132 aus dem Kühlkreislauf 111 herausgenommen wird, sobald die Fluidtemperatur die zulässige Transformatortemperatur übersteigt. So wird vermieden, dass der Kühlkreislauf 111 zu einem Aufheizkreislauf für den Transformator 132 wird.

In der Figur 4 ist ein schematischer Überblick über eine Temperiervorrichtung 5 gezeigt, die als ihre Hauptkomponenten einen Wärmetauscher 7 und einen Latentwärmespeicher 9 umfasst. Der Wärmetauscher besteht in seiner einfachsten Ausführung aus einem Kanal 11 mit einem rechteckigen Querschnitt. Eine Wand oder Platte 13 des Kanals 11 bildet zugleich die Gehäusewand eines Wechselrichters 15, in dem eine Vielzahl, hier fünf gezeigt, von IGBTs 17 untergebracht sind. Die IGBTs 17 liegen mit einer planen Fläche an der Wand 13 an, so dass ein guter Wärmeaustausch zwischen der Wand 13 und den IBGTs 17 als Wärme generierendes, elektronisches Bauteil stattfindet. Sind die IGBTs 17 kälter als die Platte 13, so wird Wärme von der Platte 13 auf die IGBTs übertragen und sind sie wärmer als die Platte 13, wird Wärme auf die Platte 13 übertragen und von dort in den Kanal 11 abgeführt. Der Kanal 11 besitzt eine Zufuhröffnung 19 und eine Abführöffnung 21, um ein Kühlmedium 23, z.B. Luft oder Wasser durch den Kanal zirkulieren zu lassen. Im Fall von Wasser wird die Zirkulation über eine Pumpe 25 angeregt. Sollte eine höhere Wärmetauschleistung gewünscht sein, so kann die Platte 13 auf seiner in den Kanal 11 zugewandten Seite mit Blechen 27 versehen sein, die die Wärmetausch wirksame Fläche der Platte 13 vergrößert. Sollte das Kühlmedium 23 zu warm werden, so kann der Kanal 11 zu einem Labyrinth mit mäanderförmig angeordneten Zwischenwänden erweitert werden (gestrichelt gezeigt), die über die Umgebungsluft, eventuell mit Ventilatorunterstützung, gekühlt werden.

Die Eintrittsöffnung 19 des Wärmetauschers 7 ist unter Zwischenschaltung der Pumpe 25 mit einer Auslassöffnung 29 des Latentwärmespeichers 9 verbunden. Der Latentwärmespeicher 9 besteht aus drei Grundelementen 31, wie eines im Detail in der Figur 4 gezeigt ist. Dort ist ersichtlich, dass jedes Grundelement 31 ein Rohr 33 aufweist, das vorzugsweise zentrisch innerhalb eines Zylinder - förmigen Gefäßes 35 verläuft, welches vollständig geschlossen ist. So wird ein Zwischenraum 37 zwischen der äußeren Mantelwand des Gefäßes 35 und der Wand des Rohrs 33 geschaffen, in welchen ein Speichermedium 39 für die im Latentspeicher 9 zu speichernde Wärme W eingebracht ist. Für das Gefäß 35 sind andere Formen als die zylindrische denkbar, wie z.B. ein Quader.

Die Rohre 33 der einzelnen Grundelemente 31 sind durch Querverbindungen 41 miteinander verbunden, so dass ein durchgehendes Rohrsystem vorliegt, durch welches das Kühlmedium 23 strömt. Das Kühlmedium 23 betritt dabei den Latentwärmespeicher 9 über eine Einlassöffnung 43, die über eine Verrohrung mit der Abführöffnung des Wärmetauschers 7 verbunden ist.

Oberhalb der Grundelemente 31 ist ein Ventilator 45 vorgesehen, der Umgebungsluft in den Raum zwischen den Grundelementen 31 befördert, falls eine Abkühlung des Latentwärmespeichers 9 erforderlich ist.

Im Betrieb arbeitet diese alternative Temperiervorrichtung folgendermaßen: Morgens beim Anfahren der PV-Anlage bleiben, falls der Latentwärmespeicher 9 vollständig entleert war und deswegen kein Halten der IGBTs 17 auf der Betriebstemperatur erfolgen konnte, zunächst sowohl die Pumpe 25, als auch der Ventilator 45 ausgeschaltet, um die IGBTs 17 auf die gewünschte Betriebstemperatur zu bringen. Die Temperatur wird z.B. an der Platte 13 gemessen oder an einem oder mehreren der IGBTs mittels dort angebrachter Temperatursensoren S gemessen. Die gemessene Temperatur wird mit einem Temperaturwert verglichen, der das Erreichen der gewünschten Betriebstemperatur widerspiegelt. Es kann beispielsweise zuvor ermittelt werden sein, dass eine Plattentemperatur von 80°C einer gewünschten Betriebstemperatur der IGBTs von 90°C entspricht, wovon im Weiteren ausgegangen werden soll.

Bei Überschreiten eines oberen Schwellwerts der Temperatur, z.B. um 3°C, wird zunächst die Pumpe 25 in Gang gesetzt, wodurch sich das Kühlmedium erwärmt und die Wärme von der Platte 13 hin zum Latentwärmespeicher 9 transportiert wird. Dabei wird die Temperatur an der Platte 13 permanent beobachtet und bei einer Unterschreitung eines unteren Grenzwerts von z.B. minus 3°C wird die Pumpe wieder abgeschaltet. Dieser Regelkreis von Zuschalten und Abschalten der Pumpe 25 in Abhängigkeit der Plattentemperatur wird so gesteuert, dass die Plattentemperatur in dem genannten Bereich von 80°C plus/minus 3°C, also zwischen 77°C und 83 °C liegt. Diese Regelung wird beibehalten, bis der Latentwärmespeicher 9 gefüllt ist, was einer gespeicherten Wärme W bis zum zweiten Knickpunkt 3 der Verlaufskurve in Fig. 1 entspricht. Es droht somit ein Anstieg der Plattentemperatur über die 83°C hinaus, was dadurch vermieden wird, dass der Ventilator 45 zugeschaltet wird. Die Größe, Anzahl und Bauweise der Grundelemente 31 ist so bemessen, dass bei ungestörter Sonneneinstrahlung im Sommer die im Volllastbetrieb arbeitenden IGBTs 17 nicht mehr Abwärme erzeugen als über die Ventilation abtransportiert werden kann. Der Ventilator 45 wird in seiner Leistung (entsprechend Umdrehungszahl) so gesteuert, dass die Plattentemperatur im Bereich zwischen 77°C und 83°C verbleibt.

Gegen Abend wird die Sonneneinstrahlung weniger, bis sie vollständig ausbleibt. Die IGBTs 17 produzieren erst eine verminderte und schließlich keine Eigenerwärmung mehr, da weniger und dann keine Umwandlung von Gleichstrom in Wechselstrom erfolgt. Entsprechend wird zunächst der Ventilator 45 abgeschaltet, damit die gespeicherte Wärme nicht nutzlos in die Umgebung verschwindet. Dann wird entsprechend der Regelgröße "Plattentemperatur" die Pumpe 25 so gesteuert, dass immer nur so viel Wärme aus dem Latentwärmespeicher 9 an die Platte 13 abgegeben wird, um deren Temperatur im Zielbereich von 77°C bis 83°C zu halten. Je nach Größe des Latentwärmespeichers 9 in Bezug auf die beteiligten Parameter wie die Anzahl an IGBTs, die Größe der Platte 13, den Wärmübergangskoeffizienten, Nachttemperatur der Umgebung etc. sollte die Kapazität des Latentwärmespeichers 9 idealer Weise ausreichen, um ohne das eingangs geschilderte Aufheizen des Speichers 9 nahtlos an den Betrieb der PV- Anlage am folgenden Tag anschließen zu können, ohne dass überhaupt eine Absenkung der gewünschten Betriebstemperatur der IGBTs, entsprechend einem Absinken der Plattentemperatur unterhalb von 77°C stattgefunden hat.

Grundsätzlich ist auch ein voraussschauendes Kühlen durchführbar, indem auf meteorologische Daten eines Wetterdienstes zurückgegriffen wird. Ist zum Beispiel eine überdurchschnittlich wolkenfreie und heiße Mittagszeit zu erwarten, so kann in den Vormittagsstunden der Kühler 116 über das notwendige Maß hinaus die Wärme abführen, um den gesamten Zirkulationskreislauf am unteren empfohlenen Grenzwert zu halten, bei dem die elektronische Bauelemente noch einwandfrei arbeiten. Die so aufgebaute Kapazität an noch zusätzlich zur Verfügung stehender Kälte kann dann mittags verbraucht werden, um sie in das Kühlsystem einzubringen.

In der Figur 5 ist eine Variante der Platte 13 des Kanals 11 gezeigt, in der zur Erzielung einer spontaneren Wärmeübertragung zwischen dem Kühlmedium 23 und der Platte 13 diese an ihrer dem Kanal 11 zugewandten Seite mit Kühlfinnen oder Kühlrippen 47 versehen ist.

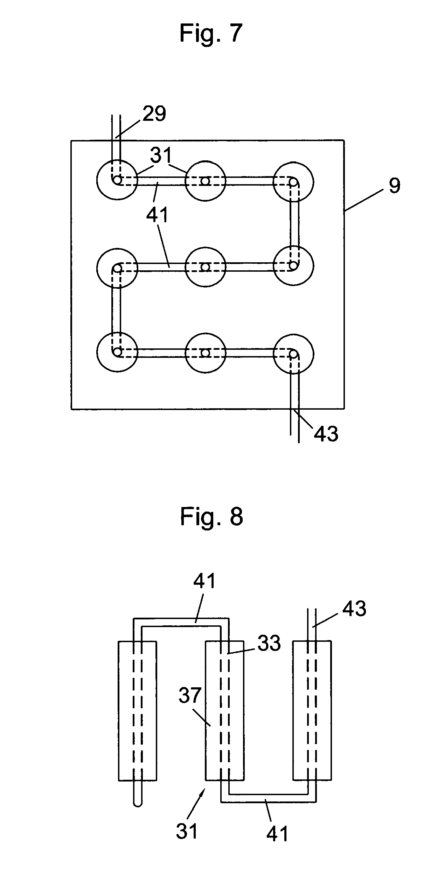

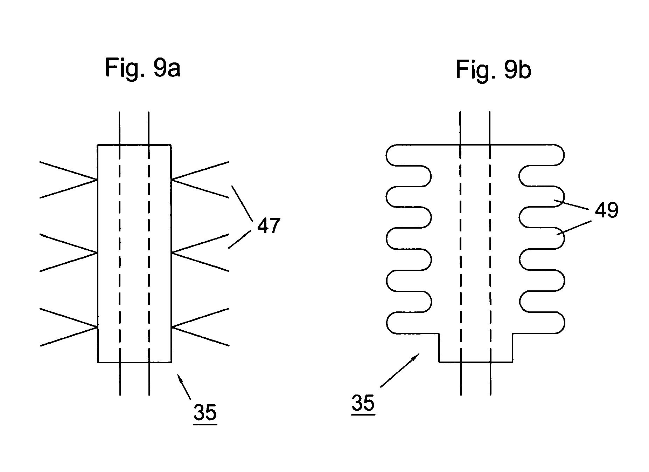

Die Figuren 7 und 9 zeigen einen Latentwärmespeicher 9 mit neun Grundelementen 31 von denen das erste die Einlassöffnung 43 zur Verbindung mit der Abführöffnung 21 des Wärmetauschers 7 aufweist und das neunte Grundelement 31 entsprechend die Auslassöffnung 29 zur Verbindung mit der Zuführöffnung 19 am Wärmetauscher 7. Die dazwischen liegenden sieben Grundelemente 31 sind mit den Randelementen und untereinander mittels der Querverbindungen 41 verbunden. Im Ergebnis liegt eine Reihenanordnung der Grundelemente 31 vor, bei denen die Rohre 33 eine durchgehende, mäanderförmige Leitung bilden. Über der Anordnung, die beispielsweise in einem Gitterrahmen (nicht gezeigt) montiert ist, ist der Ventilator 45 angeordnet, der der Übersichtlichkeit halber in der Figur weggelassen wurde.

Wie es bereits an anderer Stelle ausgeführt wurde, ist die Größe, Anzahl und Bauweise der Grundelemente 31 so bemessen, dass bei ungestörter Sonneneinstrahlung im Sommer die im Volllastbetrieb arbeitenden IGBTs 17 nicht mehr Wärme erzeugen als über die Ventilation abtransportiert werden kann. Die in Figur 9a gezeigten Kühllamellen oder Kühlfinnen 47 erhöhen den Wärmeübertragungskoeffizienten, ebenso wie die in der Figur 9b gezeigte andere Form des Gefäßes 35, bei dem die Außenwand zur Erzielung einer größeren Fläche mit Lamellen 49 versehen ist.

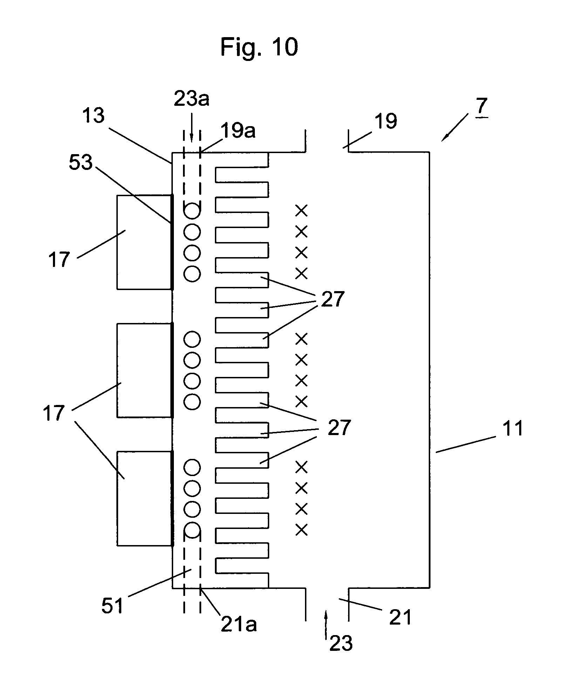

In der Fig. 10 ist ein Wärmetauscher 7 zwei Wärmetransportmitteln 23 und 23a gezeigt. Das Wärmetransportmittel 23 ist beispielsweise Luft, die mittels eines Ventilators (nicht gezeigt), der die Pumpe 25 ersetzt, in den Kanal 11 eingeführt wird. Zusätzlich ist in der Platte 13 in unmittelbarer Nähe unterhalb der Wärme erzeugenden IGBTs 15 ein Rohrsystem 51 vorgesehen, welches mäanderförmig in der Platte 13 verläuft. Durch dieses Rohrsystem wird das zweite Wärmetransportmittel 23a, z.B. Wasser, durch eine Zuführöffnung 19a eingeführt und an einer Abführöffnung 21 a wieder entnommen. Die IGBTs 17 sind dabei flächig und ohne Lufteinschlüsse mittels eines wärmeleitenden Klebers 53 mit der Platte 13 verbunden oder an sie angeschweißt.

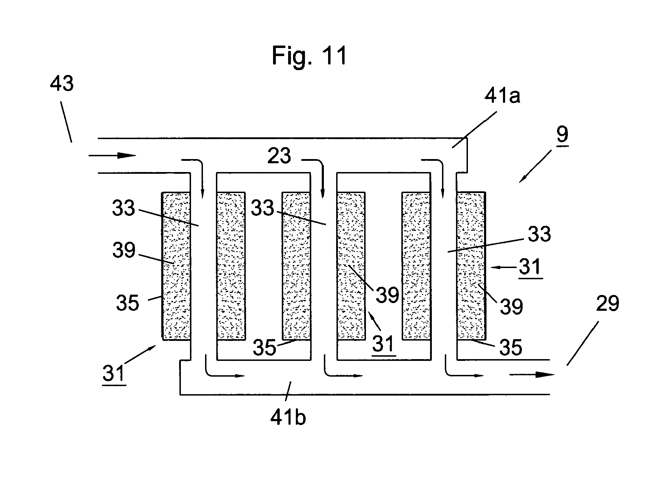

Die Figur 11 zeigt eine alternative Anordnung von Grundelementen 31, die den Latentwärmespeicher 9 bilden. Eine obere Querverbindung 41 a dient dabei als Sammelleitung, von der die Rohre 33 parallel abgehen und in eine untere als Sammelleitung fungierende Querverbindung 41 b münden. Die Ausführung der Grundelemente 31 und ihre Belüftung mittels des Ventilators 45 kann analog zu den zuvor beschriebenen Ausführungsformen ausgeführt sein.

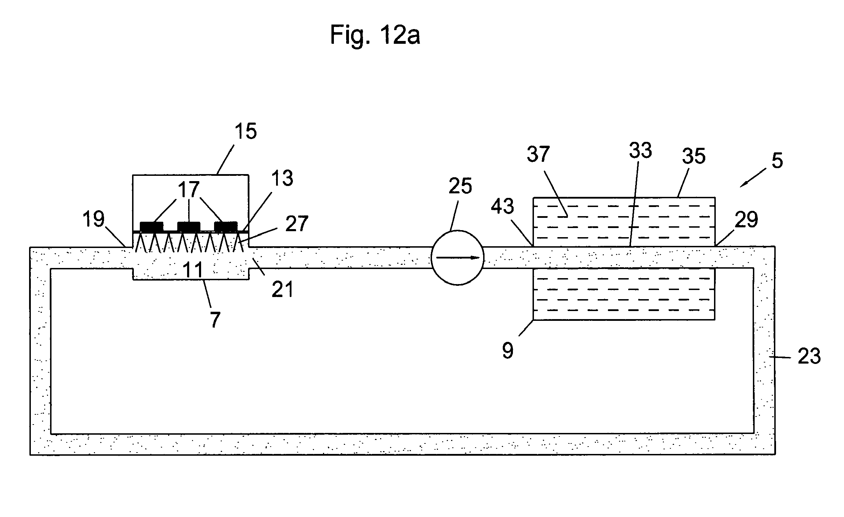

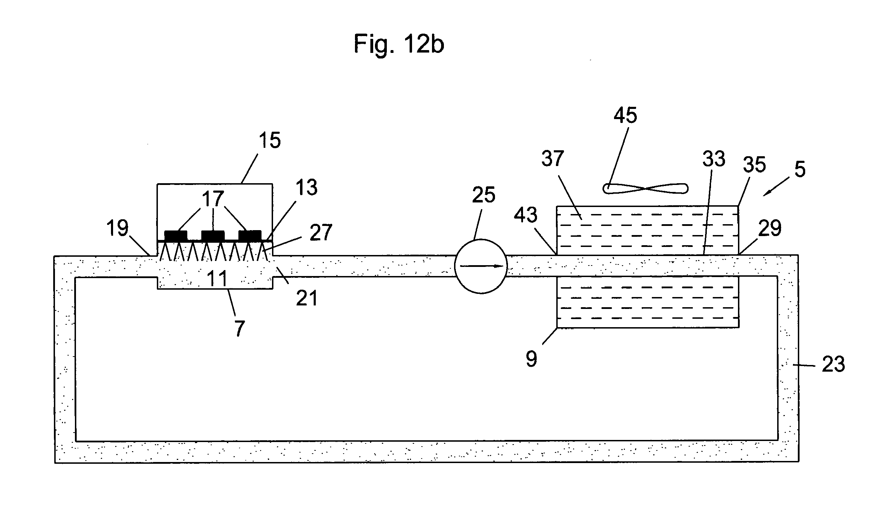

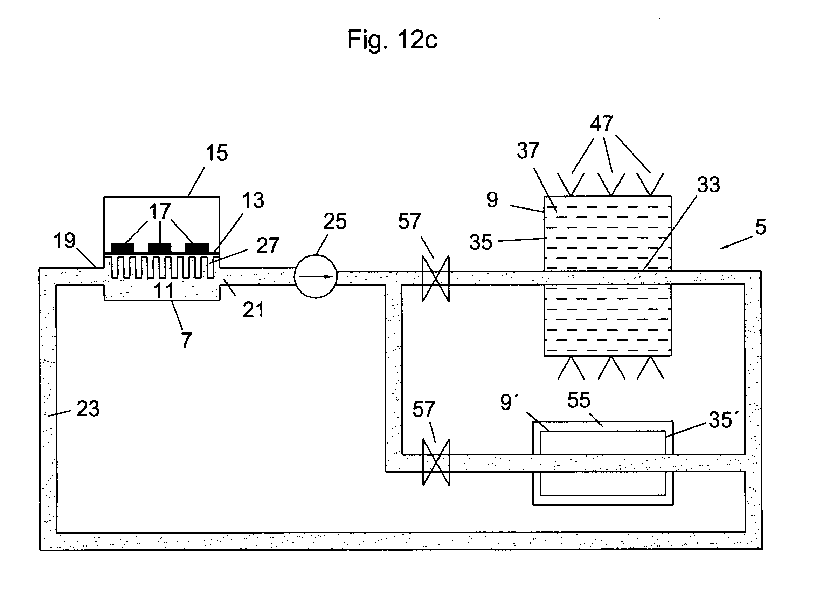

In der Figur 12 sind drei verschiedene Betriebsmodi a), b) und c) für den Latentwärmespeicher 9 dargestellt. Im Betriebsmodus a) ist der Latentwärmespeicher 9 über die Pumpe 25 mit dem Wärmetauscher 7 verbunden. Die Alternative b) sieht noch das Zuschalten des Ventilators 45 voe. Der Latentwärmespeicher wird nachts vollständig entleert, so dass er tagsüber die, durch einen Betrieb des Wechselrichters über seine Nennleistung hinaus bedingte Erwärmung der IGBTs 17 absorbieren kann. Es ist dann pro Tag lediglich ein einziger Temperaturlastwechsel der IGBTs erforderlich.

Dieser eine Temperaturlastwechsel kann noch vermieden werden, indem ein zweiter Latentwärmespeicher 9' vorgesehen wird, der zu dem ersten Latentwärmespeicher 9 parallel geschaltet ist. Der zweite Latentwärmespeicher 9' ist kleiner ausgelegt als der erste und weist ein Gefäß 35 auf, welches von einer thermischen Isolierschicht 55 umgeben ist. Der Einfachheit halber sind die beiden Latentwärmespeicher über Ventile 57 mit demselben Leitungssystem zum Wärmetauscher 7 verbunden. Je nach Stellung der Ventile 57 wird dann entweder nur der Latentwärmespeicher 9, nur der Latentwärmespeicher 9' oder beide gemeinsam, eventuell eingedrosselt, mit dem Wärmetauscher verbunden. Es sind auch getrennte Leitungssysteme denkbar, so z.B. mit einem Anschluss des kleinen Latentwärmespeichers 9' an das Wasser durchflossene Rohrsystem 51 nach der Figur 10 in Kombination mit einem Luft durchströmten Kanal 11, der an den größeren Latentwärmespeicher 9 angeschlossen ist.

Die Funktion des kleinen Latentwärmespeichers 9' ist es, die IGBTs 17 über Nacht bei Betriebstemperatur zu halten, so dass sie im gesamten Tagesverlauf nur geringen Temperaturschwankungen unterworfen sind. Die Abfuhr der in den IGBTs 17 erzeugten Wärme erfolgt dann mittels des ersten Latentwärmespeichers 9. Der erste Latentwärmespeicher 9 ist so zu bemessen, dass die gesamte überschüssige, nicht über eine normale Standardkühlvorrichtung abzuführende Wärme in ihm zwischengespeichert wird, bevor sie nachts an die Umgebung abgegeben wird.

Zusätzlich zu den beschriebenen Maßnahmen sind folgende Ausgestaltungen für sich alleine genommen oder in Kombination zueinander und/oder in Kombination mit den in den Patentansprüchen niedergelegten technischen Merkmalen sinnvoll:
- Das Speichermedium (39) des Latentwärmespeichers beruht auf Basis von Paraffin, dessen Phasenübergang fest nach flüssig auf eine Temperatur (T) zwischen 30° C und 110° C, insbesondere circa 50° C - 90° C, eingestellt ist.
- Der Wechselrichter weist mehrere IGBT's auf, die auf eine oder mehrere wärmeleitfähige Platte(n) befestigt sind und die Platte(n)bilden eine Wand eines Wärmetauschers, der von dem Fluid durchströmt wird.
- Der Latentwärmespeicher umfasst ein quaderförmiges oder zylindrisches Gefäß, in dessen Innerem, insbesondere Zentrum, ein Rohr verläuft, das mit einem Wärmetransportmedium gefüllt ist und das eine Austritts- und eine Eintrittsöffnung für das Wärmetransportmedium in Form des Fluides bereitstellt, die mit einer Wand des Wechselrichtergehäuses in Wärme tauschender Weise in Verbindung stehen.
- Mehrere Gefäße sind nebeneinander angeordnet sind, deren jeweilige Rohre bis auf die Einlassöffnung des Rohres des ersten Gefäßes und bis auf die Auslassöffnung des Rohres des letzten Gefäßes miteinander verbunden sind, wobei die Einlassöffnung des Rohres des ersten Gefäßes und die Auslassöffnung des Rohres des letzten Gefäßes mit der Abführöffnung beziehungsweise der Zuführöffnung des Wärmetauschers verbunden sind, der mit dem Wechselrichtergehäuse in der Wärme tauschenden Weise in Verbindung steht.
- Die Umdrehungszahl des Ventilators und/oder der Umwälzpumpe sind über eine Regel- und Steuereinheit in Abhängigkeit von zumindest einer der Größen:
   Temperatur des IGBT, Umgebungstemperatur, Temperatur des Fluides, Temperatur des Speichermediums und Temperatur im Gehäuseinneren des Wechselrichters einstellbar.
- Der Latentwärmespeicher ist zumindest teilweise gegenüber seiner Umgebung thermisch isoliert ist.
- Der erste oder der zweite Latentwärmespeicher umfasst einen nicht thermisch isolierten Latentwärmespeicher und einen kleineren, thermisch isolierten Latentwärmespeicher.
- Die Zuführung des Wärmetransportmittels zum kleineren Latentwärmespeicher ist über ein weiteres Ventil steuerbar und abschaltbar.
- Der Wärmetauscher umfasst zusätzlich zu dem vom ersten Wärmetransportmittel durchströmten Kanal ein Rohrsystem in unmittelbarer Nähe unterhalb der IGBTs, durch welches ein zweites Wärmetransportmedium fließt.
- Der Latentwärmespeicher selber ist vorzugsweise ein quaderförmiges oder zylindrisches Gefäß, in dessen Zentrumsachse ein Rohr verläuft, durch das das Wärmetransportmedium fließt.

Die zuvor aufgeführten Maßnahmen sind dabei mit folgenden Vorteilen behaftet. Der Zwischenraum zwischen der Außenseite des Rohrs und der Innenseite des Gefäßes ist bis auf einen, ein Ausdehnungsvolumen bildenden kleinen Teil mit dem Speichermedium, e.g. Parafin, gefüllt. Das Rohr hat eine Austritts- und eine Eintrittsöffnung für das Wärmetransportmedium. Anstelle eines einzigen großen Gefäßes, das ein relativ träges Wärmeübergangsverhalten hat, können vorzugsweise mehrere Gefäße nebeneinander angeordnet sein, deren jeweilige Rohre bis auf die Eintrittsöffnung des Rohres des ersten Gefäßes und die Austrittsöffnung des Rohres des letzten Gefäßes miteinander verbunden sind. Die von der Querverrohrung unter den in Reihe geschalteten Gefäßen ausgenommene Eintrittsöffnung des ersten Gefäßes und die Austrittsöffnung des letzten Gefäßes sind mit dem Wärmetauscher verbunden.

Zur Erzielung einer guten Gleichmäßigkeit der Betriebstemperatur der IGBTs sollte das Wärmetransportmedium mittels einer Umwälzpumpe zirkuliert werden. Dies ermöglicht auf einfache Weise das schnelle Aufheizen der IGBTs am Morgen, indem die Umwälzpumpe zunächst abgeschaltet bleibt, bis die gewünschte Betriebstemperatur erreicht ist. Dann wird die Umwälzpumpe angestellt und die an den IGBTs anfallende Wärme, die ansonsten zu einer weiteren Aufheizung derselben führen würde, wird an das Speichermedium abgegeben, bis die Phasenumandlung abgeschlossen ist, was am zweiten Knickpunkt 3 der Fall ist. Dann wird eine Ventilatorkühlung initiiert, die entweder die an den IGBTs entstehende Wärme direkt abführt, indem diese angeblasen werden, oder die Wärme wird indirekt abgeführt, indem das Wärmetransportmedium weiter zirkuliert wird, dabei aber gleichzeitig über einen Ventilator abgekühlt wird. Um diesen Wärmeentzug zu unterstützen können die äußeren Umfangsflächen des Gefäßes mit Kühlrippen versehen sein, wobei ein zusätzlicher, ansteuerbarer Ventilator die Umgebungsluft in Richtung des oder der Gefäß(e) bläst. Bei der Aufstellung der PV-Anlage in heißen Regionen, die nachts sehr stärk abkühlen, kann es vorteilhaft sein, einen Teil der Gefäße thermisch zu isolieren, damit sie ihre Wärme nicht an die Umgebung abgeben. Diese isolierten Gefäße werden dann nachts gezielt thermisch entleert, z.B. durch eine Zirkulation des Wärmetransportmittels durch ein Rohrsystem, welches in der Platte in unmittelbarer Nähe der IGBTs verläuft. Dieses ist in der speziellen Beschreibung anhand der Figur 8 näher gezeigt.

Zur Erzielung der gewünschten Qualität der Vergleichmäßigung der Betriebstemperatur sollte die Umdrehungszahl des Ventilators und/oder die Fördermenge der Umwälzpumpe über eine Regel- und Steuereinheit in Abhängigkeit von zumindest einer der folgenden Größen geregelt sein: Temperatur des IGBT, Umgebungstemperatur, Temperatur des Wärmetransportmediums, Temperatur des Speichermediums und/oder Temperatur im Gehäuseinneren des Wechselrichters. Ein geeignetes Speichermedium des Latentwärmespeichers beruht auf der Basis von Paraffin, dessen Phasenübergang - fest nach flüssig - auf eine Temperatur zwischen 30° C und 110° C, insbesondere circa 50° C - 90° C, einstellbar ist. Die Einstellbarkeit ergibt sich aus dem richtigen Mischungsverhältnis zwischen langkettigen und kurzkettigen Paraffinmolekülen mit dem die gewählte Solltemperatur, bei welcher der Phasenübergang abläuft und die IGBTs betrieben werden sollen, bestimmt werden kann.

Ein guter und direkter Wärmeübergang vom IGBT zum Latentwärmespeicher lässt sich erreichen, wenn der oder die IGBT(s) auf einer wärmeleitfähigen Platte befestigt sind, die Teil eines Wärmetauschers ist, durch den das Fluid, z.B. Luft oder Wasser fließt. Dabei kann die Platte vorzugsweise unmittelbar eine Wand des Wärmetauschers bilden. Der Wärmetauscher ist im einfachsten Fall ein Schacht oder ein Kanal mit rechteckigem Querschnitt, durch den das Speichertransportmedium fließt, um die von den IGBTs erzeugte Wärme aufzunehmen oder Wärme vom Latentwärmespeicher an diese abzugeben. Die IGBT's sind dann unmittelbar an einer Wand des Wärmetauschers flächig anliegend befestigt.

### Bezugszeichenliste

- 100: Wechselrichter
- 102: Photovoltaikgenerator
- 104: Versorgungsnetz
- 106: Zulauf
- 108: Ablauf
- 110: Fluid
- 111: Pfeil
- 112: Umwälzpumpe
- 114: erster Temperaturfühler
- 116: Kühler
- 118: Lüfterpropeller
- 120: erster Latentwärmespeicher
- 122: zweiter Latentwärmespeicher
- 124: zweiter Temperaturfühler
- 126: Zwei- oder Dreiwegeventil
- 128: Bypass
- 129: dritter Temperaturfühler
- 130: Regel- und Steuereinheit
- 132: Transformator
- 134: Schaltanlage
- 140: weiterer Bypass
- 142: weiteres Zwei- oder Dreiwegeventil
- S: Temperatursensor
- T: Temperatur
- W: gespeicherte Wärme
- 1: erster Knickpunkt
- 3: zweiter Knickpunkt
- 5: Temperiereinrichtung
- 7: Wärmetauscher
- 9: Latentwärmespeicher
- 11: Kanal
- 13: Platte
- 15: Wechselrichter
- 17: IGBT
- 19,19a: Zuführöffnung
- 21,21 a: Abführöffnung
- 23,23a: Wärmetransportmedium
- 25: Pumpe
- 27: Blech
- 29: Auslassöffnung
- 31: Grundelement
- 33: Rohr
- 35: Gefäß
- 37: Zwischenraum
- 39: Speichermedium
- 41,41 a,41 b: Querverbindung
- 43: Einlassöffnung
- 45: Ventilator
- 47: Kühlfinne
- 49: Kühllamelle
- 51: Rohrsystem
- 53: Klebemittel

## Patentansprüche

1. Kühlsystem für elektronische Bauelemente, insbesondere für die IGBT's eines Wechselrichters (100), mit einem geschlossenen, ein zirkulierendes Fluid (110) enthaltenden Kühlkreislauf (111), welcher ausgehend von den Bauelementen in Zirkulationsrichtung einen belüfteten Kühler (116) umfasst, der von dem Fluid durch- oder umströmt wird, um Wärme an die Umgebung abzugeben, **dadurch gekennzeichnet, dass** hinter dem Kühler ein erster Latentwärmespeicher (120) mit dem Fluid in Wirkverbindung steht.

2. Kühlsystem nach Anspruch 1, **dadurch gekennzeichnet, dass** der Kühler (116) aktiv belüftet und in seiner Leistung regelbar ist.

3. Kühlsystem nach Anspruch 1 oder 2, **dadurch gekennzeichnet, dass** hinter dem ersten Latentwärmespeicher (120) ein zweiter Latentwärmespeicher (122) angeordnet ist.

4. Kühlsystem nach einem der Ansprüche 1 bis 3, **dadurch gekennzeichnet, dass** im Strömungsabschnitt, in dem sich der oder die Latentwärmespeicher (120,122) befinden, ein Temperaturfühler (124) angeordnet ist, der die Temperatur des Fluides (110) misst.

5. Kühlsystem nach Anspruch 3 oder 4, **dadurch gekennzeichnet, dass** der zweite Latentwärmespeicher (122) auf eine andere Phasenübergangstemperatur ausgelegt ist, als der erste Latentwärmespeicher (120).

6. Kühlsystem nach einem der Ansprüche 1 bis 5, **dadurch gekennzeichnet, dass** der erste und/oder der zweite Latentwärmespeicher (120,122) durch ein Umgehungsrohr (128) überbrückt ist, welches von einem Ventil (126) freigegeben wird, solange die Temperatur des Fluides (110) am Kühlerausgang einen vorgebbaren Grenzwert unterschreitet.

7. Kühlsystem nach einem der Ansprüche 1 bis 6, **dadurch gekennzeichnet, dass** im Strömungsabschnitt zwischen dem Wechselrichter (100) und dem Kühler (116) ein weiterer Temperaturfühler (114) angeordnet ist

8. Kühlsystem nach einem der Ansprüche 5 bis 7, **dadurch gekennzeichnet, dass** einer der beiden Latentwärmespeicher (120, 122) in den Kühlkreislauf zuschaltbar ist

9. Kühlsystem nach einem der Ansprüche 1 bis 8, **dadurch gekennzeichnet, dass** in seinem Kühlkreislauf ein elektrisch mit den Bauelementen verbundener Transformator (132) derart angekoppelt ist, dass das Fluid (110) den Kühler (116), den Latentwärmespeicher (120,122) und zumindest einen Teil des Transformators durchströmt.

10. Kühlsystem nach Anspruch 6, **dadurch gekennzeichnet, dass** außer dem schaltbaren Ventil (126) keine weitere Möglichkeit zu konstruktiven Eingriffen in den Kühlkreislauf vorgesehen ist.

11. Verfahren zum Betrieb eines Kühlsystems nach einem der Ansprüche 1 bis 10, **dadurch gekennzeichnet, dass** zunächst unter Regelung der Drehzahl der Umwälzpumpe 112 und/oder der Drehzahl des Lüfters die Wärmeabfuhr durchgeführt wird, ohne den Latentwärmespeicher (120, 122) in die Wärmeabfuhr einzubeziehen.
